# EUROPEAN PATENT APPLICATION

(11) **EP 2 530 730 A1**
(43) Date of publication of application: **05.12.2012**
(21) Application number: 11737091.6
(22) Date of filing: 27.01.2011
(51) Int. Cl.: H01L 31/04

(54) **SOLAR CELL AND SOLAR CELL MODULE USING SAID SOLAR CELL**

(30) Priority: 29.01.2010 JP 2010018019
(71) Applicant: Sanyo Electric Co., Ltd., Osaka 570-8677 (JP)
(72) Inventor: MAEKAWA Akimichi, Moriguchi-shi Osaka 570-8677 (JP); SASAKI Manabu, Moriguchi-shi Osaka 570-8677 (JP)
(74) Representative: Glawe, Delfs, Moll
(86) International application number: PCT/JP2011/051602
(87) International publication number: WO 2011/093380

(57) **Abstract**

The present invention is to provide a solar cell device which is manufacturable even if a substrate has wire marks on its surfaces, without causing breakage, etc. in collector electrodes. A solar cell 10 according to the present invention includes a crystalline silicon substrate 20d. The crystalline silicon substrate 20d has its surfaces provided with collector electrodes including finger electrodes 30 and bus bar electrodes 40. The finger electrodes 30 are formed in parallel to wire marks 10b which are present in the crystalline silicon substrate 20d.

## Description

### Technical Field

The present invention relates to a solar cell and a solar cell module using said solar cell.

### Background Art

Solar cells are expected as a new source of energy since they can convert sun light which is a clean form and inexhaustible supply of energy, directly into electricity.

With increasing prevalence of solar cells, demand for silicon wafers is increasing year after year. The silicon wafers are classified into polycrystalline silicon wafers and monocrystalline silicon wafers, and they are manufactured in the following methods:

When making polycrystalline silicon wafers, a rectangular polycrystalline ingot is first made, and this polycrystalline silicon ingot is cut into a multiple number of rectangular polycrystalline silicon ingot blocks using a band saw for example. Then, these polycrystalline silicon ingot blocks are sliced into silicon wafers.

Monocrystalline silicon wafers are made from a cylindrical silicon ingot obtained by means of Czochralski method. The ingots are cut into rectangular blocks, and side surfaces including the cut surfaces are polished to prepare rectangular silicon ingot blocks. Then, these rectangular silicon ingot blocks are sliced into silicon wafers.

When slicing polycrystalline silicon ingots and monocrystalline silicon ingots, a piece of equipment called wire saw is used to cut the silicon ingots into slices (see Patent Literature 1 for example).

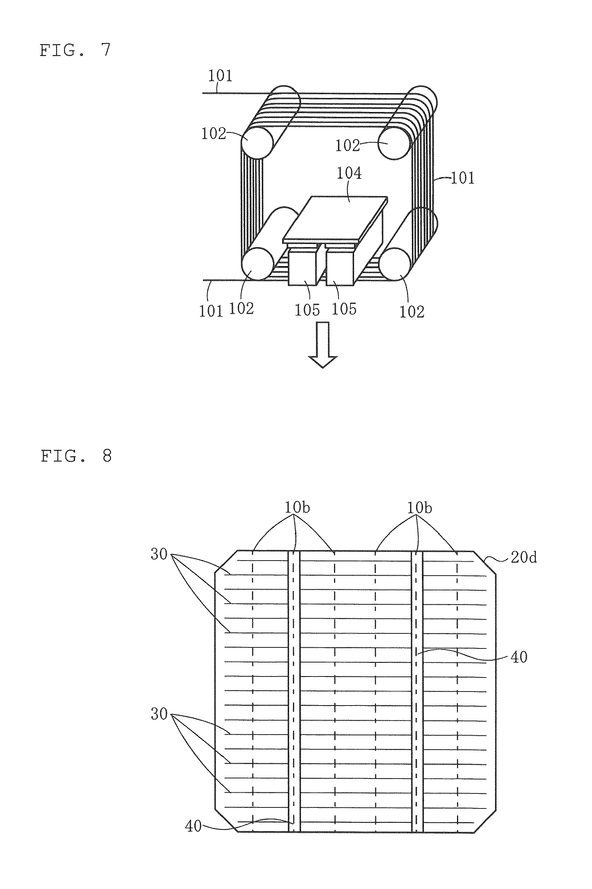

Fig. 7 is a schematic perspective view which shows a conventional method of slicing silicon ingots using a multi-wire saw. Referring to Fig. 7, the conventional method of slicing silicon ingots will be described here.

As shown in Fig. 7, silicon ingots 105 are placed in an ingot holder 104. A plurality of wires 101 are provided around four shafts 102... in such a manner that the distances to the adjacent wires 101 are equal to each other, and the wires 101 are running at a predetermined speed. While running, the wires 101 are supplied with a slurry which contains a dispersion liquid dispersed with abrasive grain, and the silicon ingots 105 are moved in a direction indicated by an arrow in Fig. 7 at a predetermined travelling speed. As the silicon ingots 105 move, the silicon ingots 105 are sliced by the wires 101 and a plurality of wafers are obtained at one time.

There are methods called fixed abrasive grain method which does not use slurry. In this case a diamond thin film or a diamond-like thin film is coated on surfaces of wire base.

In most of crystalline silicon solar cells made from the polycrystalline silicon wafers or monocrystalline silicon wafers described above, a monocrystalline or polycrystalline silicon substrate having a predetermined conductivity type has one of its front or rear surfaces formed with a p-type region and the other surface formed with an n-type region. On both of the front and rear surfaces, collector electrodes which include finger electrodes for collecting carriers from respective surfaces are formed. The collector electrodes are formed by screen printing using silver paste for example.

Also, in most of crystalline silicon solar cells, a surface treatment of forming minute concavo-convex shape is performed to the light receiving surface or both of the light receiving surface and the rear surface, in order to reduce decrease in conversion efficiency caused by light reflection.

Fig. 8 is a plan view of a solar cell, in which collector electrodes are formed on surfaces of a substrate. The solar cell includes finger electrodes 30 and bus bar electrodes 40 as collector electrodes on a substrate 20d. The finger electrodes 30 collect carriers from a photoelectric conversion unit of the solar cell. The finger electrodes 30 are formed as a multiple number of lines substantially over the entire light receiving surface of the substrate 20d. These finger electrodes 30 are formed, for example, by using an electrically conductive resin paste containing a resin material as a binder and electrically conductive particles such as silver particles as a filler.

The bus bar electrodes 40 collect carriers from the finger electrodes 30, and are formed to cross the finger electrodes 30. The bus bar electrodes 40 are formed, for example, by using an electrically conductive resin paste containing a resin material as a binder and electrically conductive particles such as silver particles as a filler, like the finger electrodes 30.

### Citation List

### Patent Literature

Patent Literature 1: JP-A 2007-173721 Gazette

### Summary of Invention

### Technical Problem

Conventionally, there is a problem that the above-described finger electrodes are broken, resulting in decrease in output characteristics. This problem became more significant as the substrate were made thinner.

An object of the present invention is to reduce breakage of the finger electrodes and provide a solar cell which has improved output characteristics.

### Solution to Problem

The inventors of the present invention conducted close examination into causes of the broken finger electrodes and found the following: Silicon wafers sliced by a wire saw have periodic wire marks (slicing marks).

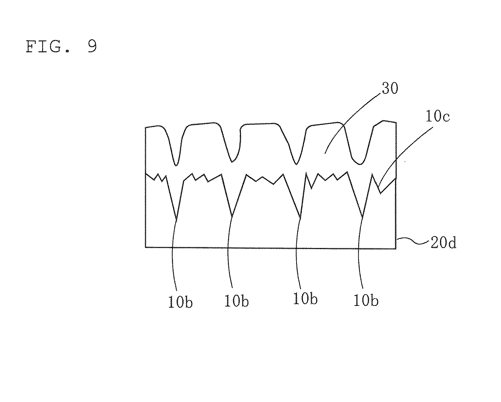

As stated above, wire marks which are made during the slicing operation appear in a periodic pattern on surfaces of the substrate. In Fig. 8, alternate long and short dash lines indicate wire marks 10b. Fig. 9 is an enlarged schematic sectional view illustrating a region formed with a finger electrode 30. These wire marks 10b as shown in Fig. 9 are formed on surfaces of the substrate 20d when wire saw method, which features a fast slicing speed and therefore leads to low cost production, is employed. The wire marks 10b are localized deep-damage layers (recesses) as compared to shallow-damage layers (recesses) in the surrounding area. As the surface including these damage layers is subjected to anisotoropic etching to form concavo-convex shape 10c, regions with deep-damage layers of the wire marks 10b, are left as recessed regions.

If the finger electrodes 30 are formed perpendicularly to these wire marks 10b, the finger electrodes 30 are formed to extend over the deep-damage layers of the wire marks 10b as shown in Fig. 9.

Occasionally, therefore, the finger electrodes 30 do not form as correctly as desired because of recessed wire marks 10b, leading to such a problem as broken finger electrodes 30.

Meanwhile, efforts are being made for reduced thickness of the substrate. However, if the thin substrate is formed with the same conventional concavo-convex shape (texture), the substrate will be susceptible to breakage. As a solution, efforts are being made to form smaller concavo-convex shape than conventional ones. As part of these efforts, the amount of etching for forming the concavo-convex shape is reduced in order to reduce the size of the concavo-convex shape.

However, reducing the amount of etching is likely to leave the wire marks, which will lead to increased incidence of finger electrode breakage. The present invention was made based on the above-described understandings.

Specifically, the present invention provides a solar cell which includes a crystalline silicon substrate, and has surfaces provided with electrodes which have finger electrodes. In this solar cell, the finger electrodes are placed in parallel to wire marks in the surfaces of the substrate.

The finger electrodes can be formed in parallel to wire marks using the wire marks in the substrate surfaces as references.

Also, the present invention provides a solar cell module which includes a plurality of solar cells and wiring members connecting the solar cells with each other. In this solar cell module, the solar cells include photoelectric conversion units, and electrodes which are formed on the photoelectric conversion units in parallel to wire marks in the substrate. Further, the wiring members are connected to overlap with the electrodes.

### Advantageous Effects of Invention

According to the present invention, the finger electrodes no longer extend over the deep-groove wire marks in the longitudinal direction. This reduces breakage of the finger electrodes and improves output from the solar cell.

### Brief Description of the Drawings

Fig. 1 is a plan view of a solar cell according to an embodiment of the present invention.
Fig. 2 is an enlarged schematic sectional view illustrating a region formed with finger electrodes in the solar cell according to the embodiment of the present invention.
Fig. 3 is a sectional view of the solar cell according to the embodiment of the present invention.
Fig. 4 is a plan view showing a state where wiring members are laid on bus bar electrodes of the solar cell shown in Fig. 1.
Fig. 5 is a sectional view showing a state where wiring members are laid on bus bar electrodes of the solar cell shown in Fig. 1.
Fig. 6 is an enlarged side view of a section of the solar cell module according to the embodiment of the present invention.
Fig. 7 is a schematic perspective view which shows a method of slicing silicon ingots using a multi-wire saw.
Fig. 8 is a plan view of a solar cell, in which collector electrodes are formed on surfaces of a substrate.
Fig. 9 is an enlarged schematic sectional view showing a region formed with a finger electrode.

### Description of Embodiments

Embodiments of the present invention will be described in detail with reference to the drawings. It should be noted here that throughout the drawings the same or equivalent parts and components will be indicated with the same reference symbols, and in order to avoid redundancy in description, their description will not be repeated. It should also be noted that all the drawings are conceptual sketches and may not reflect actual dimensional proportions, etc. Therefore, information about specific dimensions, etc. should be understood and determined from the description to be given hereafter. Keep in mind that proportional and other relationships may also differ from one drawing to another.

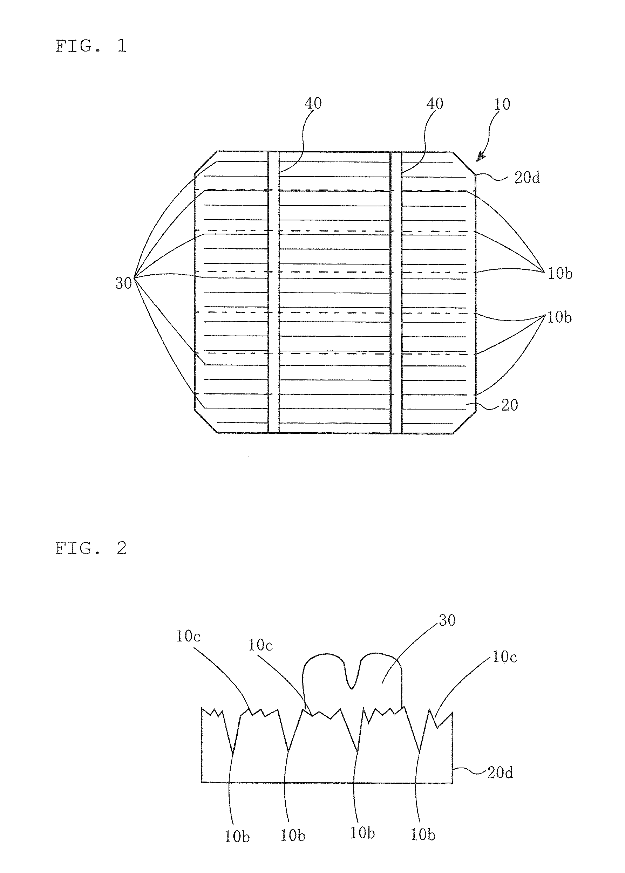

Now, reference will be made to Fig. 1 to describe a configuration of a solar cell 10 according to an embodiment of the present invention. Fig. 1 is a plan view of the solar cell 10. As shown in Fig. 1, the solar cell 10 includes a substrate 20d, photoelectric conversion unit 20, finger electrodes 30 and bus bar electrodes 40.

The photoelectric conversion unit 20 produces carriers as it receives sun light. In this Description, the term carriers refers to holes and electrons produced when the sun light is absorbed by the photoelectric conversion unit 20. The photoelectric conversion unit 20 has an n-type region and a p-type region therein, with a semiconductor junction formed in the interface between the n-type region and the p-type region. The photoelectric conversion unit 20 can be formed by using a semiconductor substrate made of a crystalline semiconductor material such as monocrystalline silicon and polycrystalline silicon. The photoelectric conversion unit 20 in this solar cell utilizes, for example, an arrangement where an intrinsic amorphous silicon layer is placed between a monocrystalline silicon layer and an amorphous silicon layer of mutually opposing conductivity types for reduced defect in the interface and improved characteristic of hetero junction interface.

The substrate 20d in the present embodiment is made by slicing a polycrystalline silicon ingot or a monocrystalline silicon ingot with a wire saw, and due to the slicing operation, deep grooves are formed and left as wire marks 10b on front and rear surfaces of the substrate 20d.

As shown in Fig. 2, these wire marks 10b are grooves which have a maximum width of 5 µm approx., a maximum depth of 10 µm approx., and a maximum length of 3 cm approx. Also, a surface treatment of forming minute concavo-convex shape 10c by anisotropic etching is performed to the front and rear surfaces of the substrate 20d in order to reduce decrease in conversion efficiency caused by light reflection.

As shown in Fig. 1, in the present embodiment, the finger electrodes 30 are formed in parallel to the wire marks 10b, i.e. in parallel to deep grooves, etc, which are formed in the surfaces during the slicing operation. Therefore, when setting the substrate 10b in the production line, wire marks (slicing marks) 10b are used as reference marks so that the finger electrodes 30 will be in parallel to the wire marks 10b, thereby determining manufacturing steps.

Forming the finger electrodes 30 in parallel to the slicing marks 10b as shown in Fig. 2 eliminates cases where electrodes 30 formed with a silver paste extend over the wire marks 10b in the longitudinal direction. This reduces breakage of the finger electrodes 30.

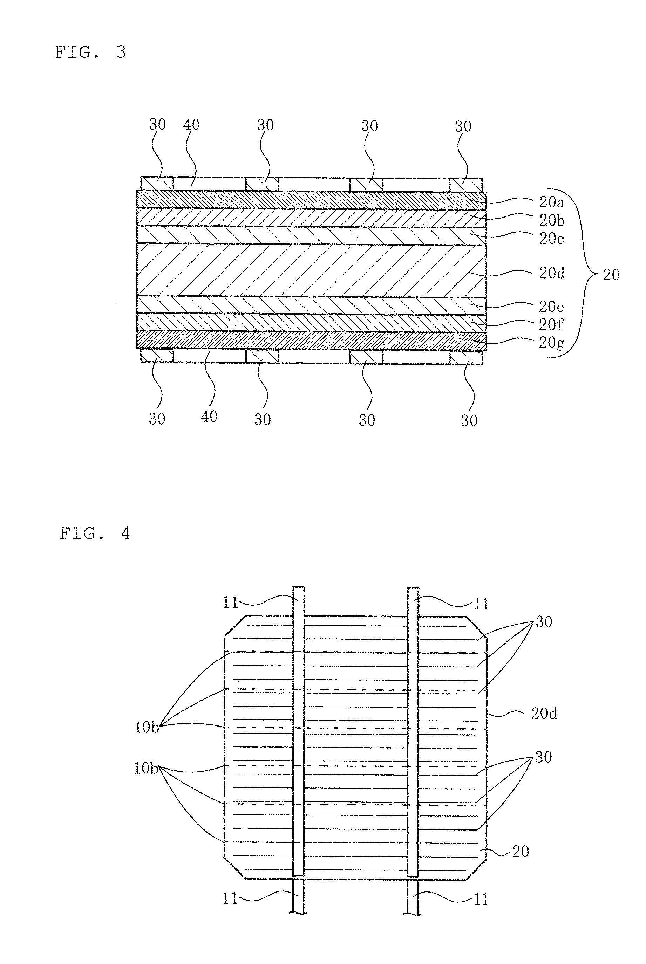

The finger electrodes described above are electrodes which collect carriers from the photoelectric conversion unit 20. As shown in Fig. 1, the finger electrodes 30 are formed like lines in parallel to the wire marks 10b. The finger electrodes 30 are formed in plurality almost entirely in the light receiving surface of the photoelectric conversion unit 20 in the substrate 20d. These finger electrodes 30 are formed, for example, by using an electrically conductive resin paste containing a resin material as a binder and electrically conductive particles such as silver particles as a filler, but the present invention is not limited to this. It should be noted here that as shown in Fig. 3, the finger electrodes 30 are formed on both of the light receiving surface and the rear surface of the photoelectric conversion unit 20 in the same manner. The finger electrodes 30 have a thickness of 50 µm approx., and a width of 100 µm through 120 µm.

The bus bar electrodes 40 are electrodes which collect carriers from the plural finger electrodes 30. As shown in Fig. 1, the bus bar electrodes 40 are formed to cross the finger electrodes 30. The bus bar electrodes 40 are formed, for example, by using an electrically conductive resin paste containing a resin material as a binder and electrically conductive particles such as silver particles as a filler, like the finger electrodes 30. However, the present invention is not limited by this. It should be noted here that as shown in Fig. 3, the bus bar electrodes 40 are formed also on the rear surface of the photoelectric conversion unit 20.

The quantity of the bus bar electrodes 40 may be determined in consideration of the size of the photoelectric conversion unit 20 for example. The solar cell 10 according to the present embodiment includes two bus bar electrodes 40, but may include three or more bus bar electrodes. In the present embodiment, the bus bar electrodes 40 have a thickness of 50 µm, and a width of 1 mm.

The bus bar electrodes 40 are formed to cross the wire marks 10b, but since the bus bar electrodes 40 are wider than the finger electrodes 30, the risk of breakage is low. Also, as will be described later, wiring members 11 are connected on the bus bar electrodes 40, and these wiring members 11 will ensure electrical conductivity even if there are partial breakage.

Although the bus bar electrodes 40 described above are formed in straight line pattern, they may be formed in a zigzag pattern.

Next, description will cover, as an example configuration of the solar cell 10, a case where the photoelectric conversion unit 20 utilizes an arrangement in which an intrinsic amorphous silicon layer is placed between a monocrystalline silicon layer and an amorphous silicon layer of mutually opposing conductivity types for reduced defect in the interface and improved characteristic of hetero junction interface. Reference will be made to Fig. 3.

As shown in Fig. 3, the photoelectric conversion unit 20 includes a transparent conductive layer 20a, a p-type amorphous silicon layer 20b, an intrinsic (i-type) amorphous silicon layer 20c, an n-type monocrystalline silicon substrate 20d, an i-type amorphous silicon layer 20e, an n-type amorphous silicon layer 20f and a transparent conductive layer 20g.

The n-type monocrystalline silicon substrate 20d has its light receiving surface side formed with the p-type amorphous silicon layer 20b via the i-type amorphous silicon layer 20c. The p-type amorphous silicon layer 20b has its light receiving surface side formed with the transparent conductive layer 20a. On the other hand, the n-type monocrystalline silicon substrate 20d has its rear surface side formed with the n-type amorphous silicon layer 20f via the i-type amorphous silicon layer 20e. The n-type amorphous silicon layer 20f has its rear surface side formed with the transparent conductive layer 20g.

The finger electrodes 30 and the bus bar electrodes 40 are formed on each of the light receiving surface side of the transparent conductive layer 20a and the rear surface side of the transparent conductive layer 20g.

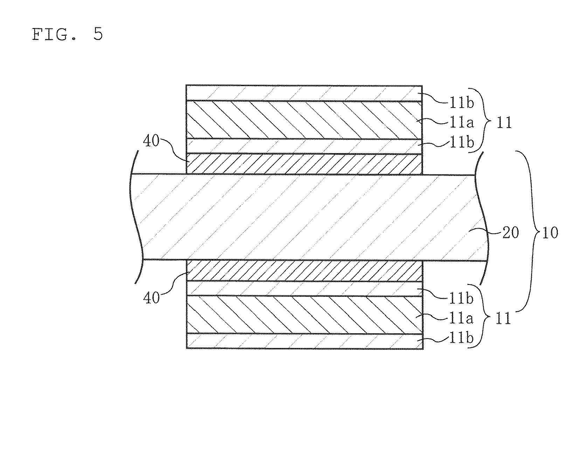

Next, description will cover a solar cell string 1 and a solar cell module 1a, with reference to Fig. 4 through Fig. 6. Fig. 4 is a plan view showing a state where wiring members 11 are laid on the bus bar electrodes 40 of the solar cell 10 which is shown in Fig. 1 through Fig. 3 whereas Fig. 5 is an enlarged sectional view of a bus bar electrode region.

As shown in Fig. 4 and Fig. 5, the wiring members 11 are disposed along the bus bar electrodes 40. Specifically, the wiring members 11 are disposed on the bus bar electrodes 40 of the solar cell 10. The wiring members 11 have a width which is substantially the same as of the bus bar electrodes 40. The wiring members 11 are in contact with the bus bar electrodes 40.

As described, the bus bar electrodes 40 and the wiring members 11 are disposed on the photoelectric conversion unit 20. Further, the wiring members 11 and the bus bar electrodes 40 are electrically connected with each other by solder.

As shown in Fig. 5, the wiring member 11 includes a copper foil 11a as a low-resistance member which has a thickness of 200 µm and a width of 1 mm, and solder layers 11b which are provided around the copper foil 11a and made of tin or tin-containing alloy materials.

The solder layers 11b are made of tin, Sn-Ag-Cu, Sn-Pb, Sn-Cu-Ni or others. In this embodiment, Sn-Ag-Cu solder layers 11b are provided around the copper foil 11a. As shown in Fig. 5, the wiring members 11 on the light receiving surface have the same shape as those on the rear surface.

The bus bar electrodes 40 and the wiring members 11 are disposed on the photoelectric conversion unit 20. Once these members are disposed, then the entire region including the wiring members 11 and the bus bar electrodes 40 overlapped with each other are exposed to hot air blow or infrared rays. Thus, the solder layers 11 which coat the surfaces of the wiring members 11 are melted to electrically connect the bus bar electrodes 40 with the wiring members 11.

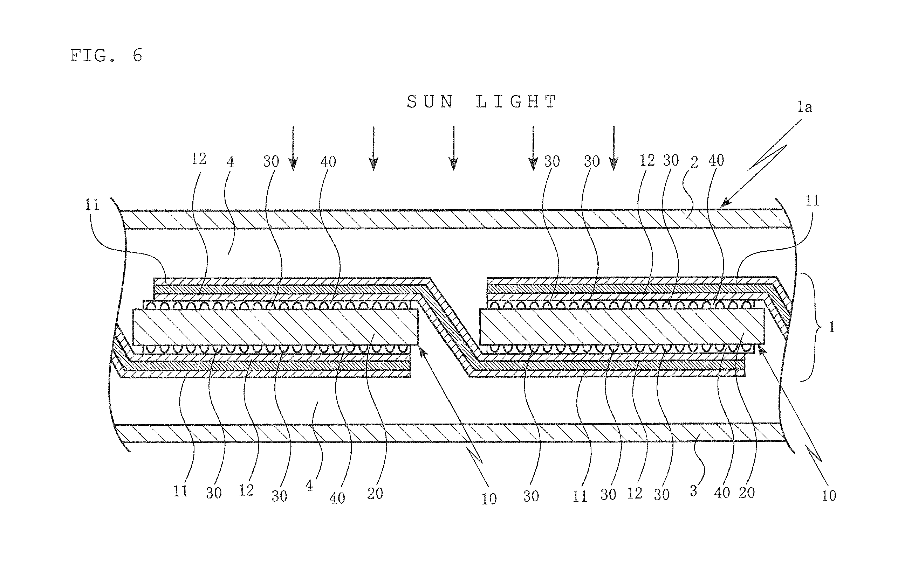

Now, reference will be made to Fig. 6 to describe general configuration of a solar cell module 1a according to the embodiment of the present invention. Fig. 6 is an enlarged side view of a section of the solar cell module 1a according to the present embodiment.

The solar cell module 1a includes solar cell strings 1, a light-receiving-surface-side protection member 2, a rear-surface-side protection member 3 and a sealing member 4. The solar cell module 1a is built by sealing the solar cell string 1 between the light-receiving-surface-side protection member 2 and the rear-surface-side protection member 3 using the sealing member 4.

The solar cell string 1 includes a plurality of the solar cell 10 and wiring members 11. The solar cell string 1 is constituted by connecting the solar cells 10 with each other using the wiring members 11.

Each solar cell 10 has a light receiving surface for solar incident, and a rear surface facing away from the light receiving surface. Each solar cell 10 has electrodes formed on its light receiving surface and its rear surface.

The wiring members 11 are connected to the electrodes formed on the light receiving surface of one solar cell 10 and to the electrodes formed on the rear surface of another solar cell 10 which is adjacent to the said solar cell. Thus, electrical connection is established between mutually adjacent solar cells 10, 10. The wiring member 11 includes a copper foil and solder which is plated on surfaces of the copper foil. The copper foil of the wiring member 11 has a thickness of 200 µm approx., and a width of 1 mm approx., while the film of solder has a thickness of 40 µm approx.

The light-receiving-surface-side protection member 2 is disposed on the light receiving surface side of the sealing member 4, and protects the front surface of the solar cell module 100. The light-receiving-surface-side protection member 2 may be provided by water-shielding transparent glass, transparent plastic, etc.

The rear-surface-side protection member 3 is disposed on the rear surface side of the sealing member 4, and protects the rear surface of the solar cell module 100. The rear-surface-side protection member 3 may be provided by a film of a resin such as PET (Polyethylene Terephthalate), or a laminated film made by sandwiching a foil of Al (aluminum) between resin films.

The sealing member 4 seals the solar cell string 1 between the light-receiving-surface-side protection member 2 and the rear-surface-side protection member 3. The sealing member 4 may be provided by a transparent resin such as EVA (ethylene vinyl acetate copolymer resin), EEA (Ethylene-methyl acrylate copolymer resin), PVB (polyvinyl butyral resin), silicone, urethane, acrylic and epoxy.

It should be noted here that the solar cell module 100 configured as the above may have an Al (aluminum) frame (unillustrated) attached therearound.

Next, description will cover measurements of output characteristics made to the solar cell according to the present invention and another solar cell for comparison. The embodiment had the finger electrodes 30 formed in parallel to the wire marks 10b as shown in Fig. 1 whereas the comparative example had the finger electrodes 30 formed perpendicularly to the wire marks 10b as shown in Fig. 8. All the other aspects of the embodiment and the comparative example are identical with each other. The following figures are relative values, with the maximum solar cell output value (Pmax) and the resistance between the bus bars (ohm) in the comparative example being 100%.

According to the embodiment of the present invention, resistance between bus bars is 98% of the resistance in the comparative example. In other words, the resistance was lower. On the other hand, the solar cell output of the embodiment was 101%, i.e., the output was improved by 1%. These can be attributed to reduced breakage of the finger electrodes 30.

Next, description will cover a method of manufacturing the solar cell module 100 according to the present embodiment.
First, a 100 mm x 100 mm n-type monocrystalline silicon substrate 20d is subjected to anisotropic etching with an alkali aqueous solution, whereby minute concavo-convex shape is formed on the light receiving surface of the n-type monocrystalline silicon substrate 20d. The light receiving surface of the n-type monocrystalline silicon substrate 20d are cleaned to remove impurities.

Next, using the wire marks 10b as references, the substrate 20d is set at an appropriate position, and then an i-type amorphous silicon layer 20c and a p-type amorphous silicon layer 20b thereon are formed in this order on the light receiving surface side of the n-type monocrystalline silicon substrate 20d by CVD (Chemical Vapor Deposition) method. Likewise, an i-type amorphous silicon layer 20e and an n-type amorphous silicon layer 20f thereon are formed in this order on the rear surface side of the n-type monocrystalline silicon substrate 20d.

Next, a transparent conductive layer 20a is formed on the light receiving surface side of the p-type amorphous silicon layer 20b, using PVD (physical vapor deposition) method. Likewise, a transparent conductive layer 20g is formed on the rear surface side of the n-type amorphous silicon layer 20f. Through the above steps, the photoelectric conversion unit 20 has been formed.

Next, using the wire marks 10b as references, the substrate 20d is set to an appropriate position, and then using a printing method such as screen printing and offset printing, an epoxy thermosetting silver paste is applied in a predetermined pattern on the light receiving surface and the rear surface of the photoelectric conversion unit 20 so that the finger electrodes 30 are placed in parallel to the wire marks 10b.

After heating under predetermined conditions to volatilize solvents, another step of heating is performed to dry the silver paste. Thereafter, a protective layer 21 is formed while leaving a resin layer 41 on part of the bus bar electrodes 40. Through the above steps, the solar cell 10 has been formed.

Next, wiring members 11 are soldered onto the bus bar electrodes 40. This establishes mechanical and electrical connection between the wiring members 11 and the solar cell 10. Specifically, first, wiring members 11 are placed on the bus bar electrodes 40 formed on the light receiving surface and the rear surface of the photoelectric conversion unit 20. Next, the wiring members 11 are heated to predetermined temperatures to melt the solder and bond the wiring members 11 to the bus bar electrodes 40. This soldering step forms bonded areas between the bus bar electrodes 40 and the wiring members 11 at an interval. Through the above steps, the solar cell string 1 has been formed.

Next, an EVA (sealing member 4) sheet, solar cell strings 1, an EVA (sealing member 4) sheet and a PET sheet (rear-surface-side protection member 3) are placed in this order on a glass substrate (light-receiving-surface-side protection member 2), to form a laminated body.

Next, the laminated body is heated under pressure in a vacuum to perform temporary pressure bonding. Thereafter, the laminated body is heated under predetermined conditions to completely set the EVA. Through the above steps, a solar cell module 1a has been completed.

The solar cell module 100 may be provided with a terminal box, an Al frame, etc.

All of the embodiments disclosed herein are to show examples, and should not be considered as of a limiting nature in any way. The scope of the present invention is identified by the claims and is not by the descriptions of the embodiments given hereabove, and it is intended that the scope includes all changes falling within equivalents in the meaning and extent of the Claims.

### Reference Signs List

- 1: solar cell string
- 2: light-receiving-surface-side protection member
- 3: rear-surface-side protection member
- 4: sealing member
- 10: solar cell
- 10b: wire marks
- 11: wiring member
- 20d: substrate
- 30: finger electrodes
- 40: bus bar electrodes
- 41: resin layer

## Claims

1. A solar cell comprising a crystalline silicon substrate and having surfaces provided with electrodes including finger electrodes,
wherein the finger electrodes are placed in parallel to wire marks in the surfaces of the substrate.

2. The solar cell according to Claim 1, wherein the finger electrodes are formed in parallel to the wire marks in the surfaces of the substrate, using the wire marks as reference marks.

3. The solar cell according to Claim 2, further comprising bus bar electrodes which cross the finger electrodes.

4. The solar cell according to Claim 3, wherein the bus bar electrodes are formed perpendicularly to the wire marks.

5. A solar cell module comprising a plurality of solar cells and wiring members electrically connecting the solar cells with each other, wherein
the solar cells include photoelectric conversion units and electrodes formed on the photoelectric conversion units in parallel to wire marks in a substrate,
the wiring members being connected to overlap with the electrodes.

6. The solar cell module according to Claim 5, wherein the electrodes include finger electrodes formed in parallel to the wire marks, and bus bar electrodes crossing the finger electrodes, the bus bar electrodes being connected to the wiring members.
